# EUROPEAN PATENT SPECIFICATION

(11) **EP 1 319 198 B1**
(45) Date of publication and mention of the grant of the patent: **17.03.2004**
(21) Application number: 00964616.7
(22) Date of filing: 12.09.2000
(51) Int. Cl.: G03F 7/30

(54) **MACHINE FOR THE TREATMENT OF PRINTING PLATES**
VORRICHTUNG ZUR BEHANDLUNG VON FLACHDRUCKPLATTEN
MACHINE DESTINEE AU TRAITEMENT DE PLAQUES D'IMPRESSION

(43) Date of publication of application: 18.06.2003
(73) Proprietor: Global Graphics Hardware, 54340 Pompey (FR)
(72) Inventor: DECARIA, Riccardo, I-20089 Basiglio (IT)
(74) Representative: Poupon, Michel
(86) International application number: PCT/IT2000/000358
(87) International publication number: WO 2002/023277

(56) References cited:
- DE-A- 3 713 329
- US-A- 4 952 961
- US-A- 5 365 629

## Description

The present invention relates to a machine for the treatment of printing plates, and in particular to a machine which can be used to remove from photopolymeric printing plates the portions not irradiated by ultraviolet light, and therefore not polymerized.

US patent n. 4952961 discloses a machine for the treatment of printing plates which includes a plurality or rotating brushes of substantially cylindrical shape, over which a support table is slid in the longitudinal and transverse direction with a substantially random motion. The plate to be treated is secured under this support table, so that it is brushed by said cylindrical brushes. Also, the brushes are partially immersed in the liquids required for the treatment, solvents in particular, which are contained in suitable containers arranged under the brushes.

However, due to the uncontrolled motion of the support table, this known machine can not perfectly remove the non-polymerized portions, and in particular does not provide an even brushing of all the points of the surface of the printing plate to be treated. Moreover, this known machine is complicated and bulky, whereby it has high costs for manufacturing, maintenance and storing.

Therefore the object of the present invention is to provide a machine free from said drawbacks. This object is achieved by means of a machine for the treatment of printing plates having the main characteristics disclosed in the first claim and other characteristics disclosed in the subsequent claims.

Thanks to the orbital movement of the rotating brushes, the machine according to the present invention can perfectly remove all the non-polymerized portions from the printing plate. Moreover, since the table supporting the printing plate is driven with a linear oscillatory motion, which is preferably varying and synchronized with the motion of the brushes, it is possible to brush evenly the whole surface of the printing plate to be treated, without the risk of obtaining plate areas brushed differently from other areas.

According to a particular aspect of the invention, the support table and the shafts of the brushes are preferably arranged on mutually parallel inclined planes, so as to easily collect the treatment liquids sprayed by suitable sprinklers and to prevent their stagnation on the printing plate. Through this arrangement the amount of liquids used for each treatment is also reduced, with subsequent economical and ecological advantages.

Finally, the machine according to the present invention has an advantageously reduced complexity and bulkiness, thanks to the particular arrangement of the brushes, support table and mechanisms for the movement thereof.

Further advantages and characteristics of the machine according to the present invention will be clear to those skilled in the art from the following detailed and non-limiting description of an embodiment thereof, with reference to the annexed drawings wherein:

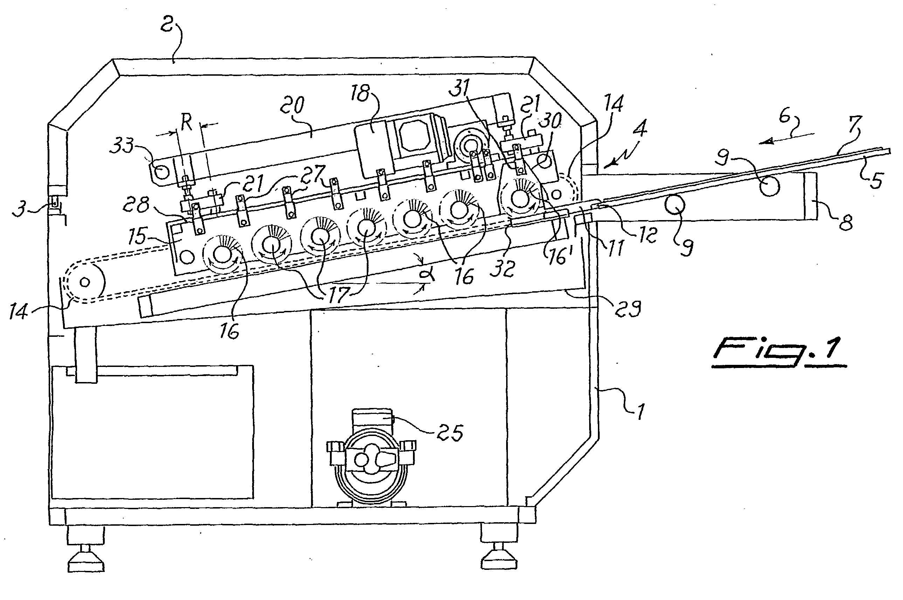

- figure 1 shows a sectional side view of the machine according to the present embodiment, before use;
- figure 2 shows a partial top plan view, slightly inclined, of the machine of figure 1;

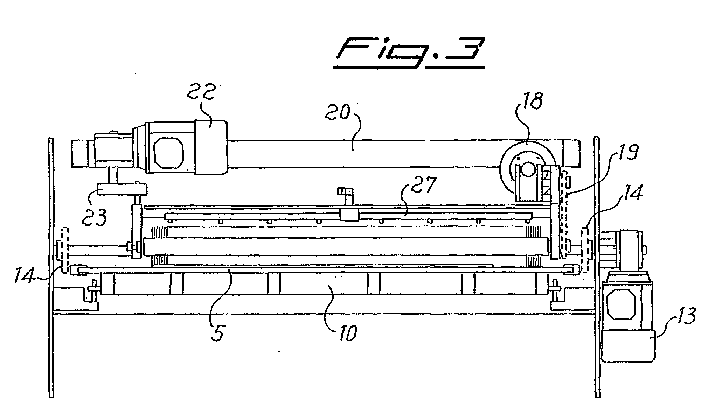

- figure 3 shows a partial front view, slightly inclined, of the machine of figure 1;
- figure 4 shows a sectional side view of the machine of figure 1 during use.

With reference to these figures, there is seen that a machine according to the present embodiment of the invention includes in a known way a case 1 closed by a top cover 2 which can be rotated upwards around a hinge 3 to gain access inside the machine, e.g. for its maintenance. Case 1 is provided with a slot 4 through which a support table 5 can be introduced in the direction indicated by arrow 6. At least one printing plate to be treated 7 can be secured, e.g. by means of biadhesive tape, onto the support table 5. In order to make easier the introduction of the support table 5 into case 1, an external frame 8 provided with a pair of idle rollers 9 is arranged adjacent to slot 4.

Inside case 1 there is arranged a plane 10 adjustable in height and inclined, in particular at an angle α of about 20°, on which the support table 5 coming from slot 4 can slide. The motion of the support table 5 is controlled by a transport plate 11 provided with a plurality of pins 12 suitable to enter corresponding holes formed in the support table 5, so as to removably engage the latter and drag it along the inclined plane 10. The longitudinal motion of the transport plate 11 is in turn provided by a motor 13 through a transmission system including a pair of chains 14 secured to plate 11.

A rectangular structure 5, also inclined at an angle α of about 20°, is properly arranged above the inclined plane 10, which structure includes a pair of side plates rotatably supporting a plurality of brushes 16 of substantially cylindrical shape. The shafts 17 of the brushes 16 are mutually parallel and arranged with their axes on a same plane parallel to the inclined plane 10. The brushes 16 project below the support structure 15 and can be rotated around their axes by a motor 18 arranged above said structure. The motion from motor 18 is transmitted to brushes 16 by a transmission system including a chain 19 stretched in a zigzag around toothed wheels keyed onto shafts 17 of brushes 16. Through this arrangement, each brush is rotated in the direction opposite with respect to the adjacent brushes. Moreover, motor 18 periodically reverses its direction of rotation, whereby each brush rotates for a same time in both directions, indicated by the curved arrows.

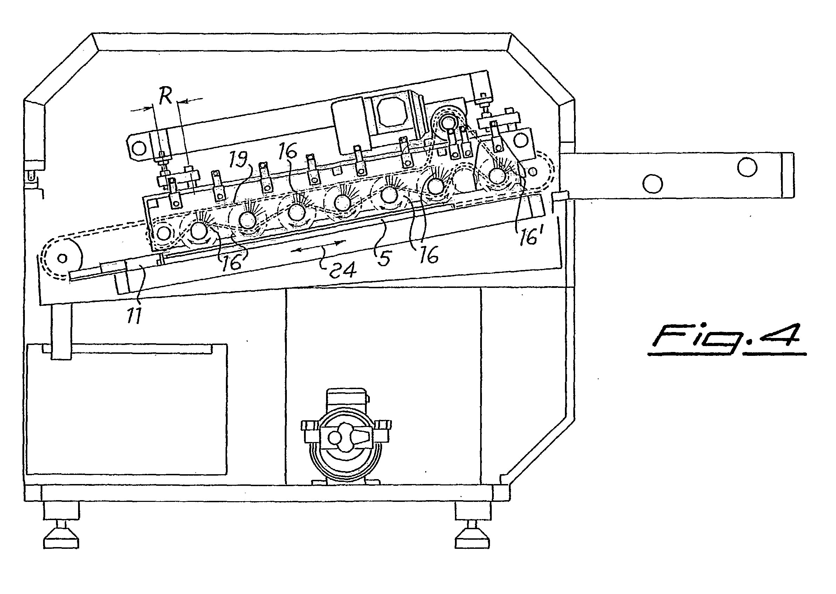

Figure 4 shows the machine according to the present embodiment with chain 19 indicated by a broken line and the support table 5 drawn beneath brushes 16 by the transport plate 11.

The structure 15 supporting brushes 16 is eccentrically pivoted onto a support frame 20 through one or more cranks 21. Thanks to a motor 22 secured to the support frame 20 and provided with a crank transmission system 23, the whole structure 15 supporting brushes 16 can be moved with an orbital motion along a plane parallel to the table 5 supporting the printing plate 7.

During the orbital motion of the support structure 15, the support table 5 with the printing plate 7 is preferably moved longitudinally along the inclined plane 10 with a linear oscillatory motion provided by motor 13 in the direction of arrow 24 of figure 4, so as to increase the uniformity of brushing of the printing plate 7. To this purpose, the oscillatory motion of the support table 5 can be synchronized with the motion of the support structure 15, so that when brushes 16 move towards slot 4, the support table 5 moves in the opposite direction, and vice versa. Furthermore, the distance between the axes of brushes 16 and the travel of the oscillatory motion of the support table 5 are substantially equal to twice the length of cranks 21, i.e. the radius R of the orbital motion.

In the orbital motion of the support structure 15, brushes 16 move longitudinally with a harmonic motion of the type x(t) = R cos(ωt), where ω is the angular velocity of cranks 21, i.e. the rotational speed of the orbital motion of brushes 16. Therefore, since the longitudinal velocity of brushes 16 is v(t) = -Rω sin(ωt), in the machine according to the present embodiment of the invention the velocity of the oscillatory motion of the support table 5 is not constant, rather it is varying, so that the relative longitudinal velocity between the support structure 15 and the support table 5 is substantially constant and each point of the printing plate 7 is brushed for the same time by brushes 16. For example, the support table 5 may be linearly accelerated when it reaches the ends of its oscillatory motion, so as to compensate for the simultaneous deceleration of brushes 16.

In order to achieve the mutual synchronization of the motions of the support structure 15 and support table 5, the rotation of the shafts of motors 13 and 22 is controlled by an electric or electronic system (not shown in the figures), in particular a known system combining an inverter with an encoder.

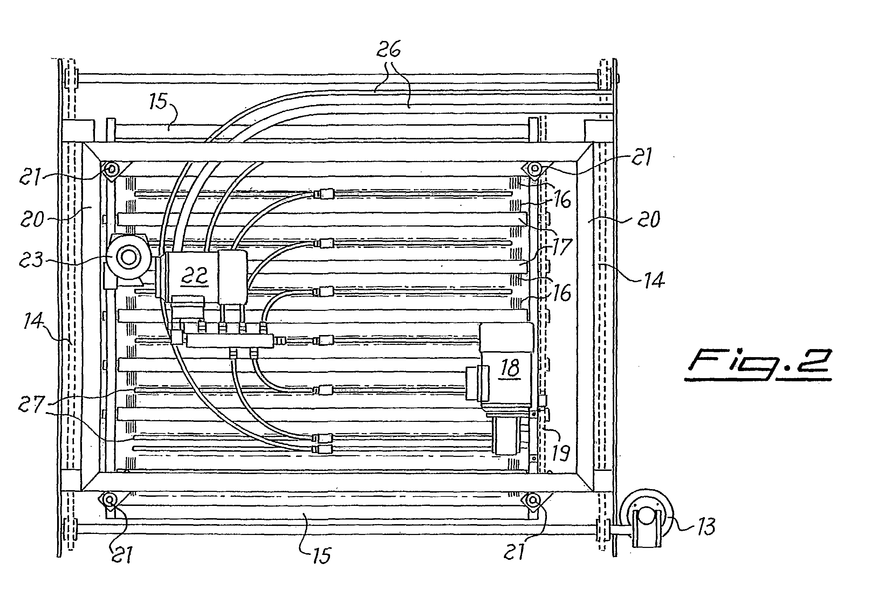

The liquids, e.g. solvents, for the treatment of the printing plate 7 are pumped during the operation of brushes 16 by a pump 25 through a plurality of ducts 26 (partially visible only in figure 2) to a series of linear sprinklers 27 arranged above brushes 16 between one brush and the other, parallel to the shafts 17 thereof. In order to prevent scattering of said liquids, the support structure 15 is preferably provided with an upper cover 28, while under the inclined plane 10 there is arranged a tank 29, also inclined, wherein the liquids are collected after use and can therefore be conveyed to pump 25 to be re-used or elsewhere.

The brush 16' closest to slot 4 is preferably provided with its own cover 30, inside which a further linear sprinkler 31 is arranged. Sprinkler 31 can therefore spray a liquid different from the liquid sprayed by sprinklers 27, e.g. pure solvent. At least a lower edge of cover 30 also includes a radial wiping blade 32 suitable to clean the bristles of brush 16'. Brush 16' provides the final cleaning of the printing plate 7 when the support table 5 is pushed out of case 1 through slot 4. After the support table 5 has come out through slot 4 and prior to be removed from the transport plate 11, an operator may check the correct treatment of the printing plate 7, whereby, in the negative, he can immediately introduce it again into case 1 for a further treatment period without touching it.

Finally, the support frame 20 is preferably pivoted along one of its edges through a hinge 33, so that it is possible to raise the whole support structure 15 when cover 2 is open and thus make easier the maintenance of the machine according to the present invention.

## Claims

1. A machine for the treatment of printing plates, which includes at least a structure (15) rotatably supporting a plurality of brushes (16) of substantially cylindrical shape having their shafts (17) mutually parallel and arranged with the axes thereof on a same plane parallel to a support table (5) on which there is secured at least one printing plate to be treated (7), said brushes (16) being suitable to be rotated by at least a first motor (18) in order to brush a surface of the printing plate (7), **characterized in that** said support structure (15) is eccentrically pivoted onto a support frame (20), so that it can be moved by a second motor (22) with an orbital motion along a plane parallel to the support table (5).

2. A machine according to the preceding claim, **characterized in that** during the orbital motion of the support structure (15), the support table (5) is longitudinally moved with a linear oscillatory motion.

3. A machine according to the preceding claim, **characterized in that** the oscillatory motion of the support table (5) is synchronized with the orbital motion of the support structure (15), so that when the brushes (16) move in a longitudinal direction the support table (5) moves in the opposite direction, and vice versa.

4. A machine according to the preceding claim, **characterized in that** the velocity of the oscillatory motion of the support table (5) is varying, so that the relative longitudinal velocity between the support structure (15) and the support table (5) is substantially constant.

5. A machine according to the preceding claim, **characterized in that** the support table (5) is linearly accelerated when it reaches the ends of its oscillatory motion.

6. A machine according to one of the preceding claims, **characterized in that** the structure (15) supporting the brushes (16) is eccentrically pivoted onto the support frame (20) through one or more cranks (21) and is connected to the second motor (22) through a crank transmission system (23).

7. A machine according to the preceding claim, **characterized in that** the distance between the axes of the brushes (16) and the travel of the oscillatory motion of the support table (5) are substantially equal to.twice the radius (R) of the orbital motion.

8. A machine according to one of the preceding claims, **characterized in that** the support table (5) is removably secured to a transport plate (11) suitable to be moved by a third motor (13) through a transmission system including a pair of chains (14) secured to the plate (11).

9. A machine according to the preceding claim, **characterized in that** the rotation of the shafts of the second (22) and third (13) motor is controlled by an electric or electronic system, in particular a system combining an inverter with an encoder.

10. A machine according to one of the preceding claims, **characterized in that** the support table (5) is slidably arranged on an inclined plane (10), in particular at an angle (α) of about 20°, which is parallel to the structure (15) supporting the brushes (16).

11. A machine according to the preceding claim, **characterized in that** the inclined plane (10) is adjustable in height.

12. A machine according to one of the preceding claims, **characterized in that** the motion of the shaft of the first motor (18) is transmitted to the brushes (16) through a transmission system including a chain (19) stretched in a zigzag around toothed wheels keyed onto the shafts (17) of the brushes (16).

13. A machine according to one of the preceding claims, **characterized in that** the first motor (18) periodically reverses its direction of rotation.

14. A machine according to one of the preceding claims, **characterized in that** it includes a pump (25) pumping liquids for the treatment of the printing plate (7) during the operation of the brushes (16) through a plurality of ducts (26) to a series of linear sprinklers (27) arranged above the brushes (16), between one brush and the other, parallel to the shafts (17) thereof.

15. A machine according to the preceding claim, **characterized in that** a brush (16') is provided with its own cover (30), inside which a further linear sprinkler (31) is arranged.

16. A machine according to the preceding claim, **characterized in that** at least one lower edge of the cover (30) includes a radial wiping blade (32) suitable to clean the bristles of said brush (16').

17. A machine according to one of the preceding claims, **characterized in that** the support frame (20) is pivoted along one of its edges through a hinge (33), so that it can be rotated upwards.

## Patentansprüche

1. Vorrichtung zur Behandlung von Druckplatten, die mindestens einen Aufbau (15) aufweist, in dem mehrere Bürsten (16) im Wesentlichen zylindrischer Form drehbar gelagert sind, wobei ihre Wellen (17) parallel zueinander angeordnet sind und deren Achsen in der gleichen Ebene liegen, die parallel zu einem Auflagetisch (5) verläuft, auf dem mindestens eine zu behandelnde Druckplatte (7) befestigt ist, wobei die genannten Bürsten (16) mittels mindestens eines ersten Motors (18) in eine Drehbewegung versetzt werden können, um eine Oberfläche der Druckplatte (7) zu bürsten, **dadurch gekennzeichnet, dass** der tragende Aufbau (15) derart auf einem Trägerrahmen (20) exzentrisch drehbar gelagert ist, dass er mittels eines zweiten Motors (22) mit einer Umlaufbewegung in einer parallel zum Auflagetisch (5) verlaufenden Ebene bewegt werden kann.

2. Vorrichtung nach dem vorhergehenden Anspruch, **dadurch gekennzeichnet, dass** während der Umlaufbewegung des tragenden Aufbaus (15) der Auflagetisch (5) mit einer linearen oszillierenden Bewegung in Längsrichtung bewegt wird.

3. Vorrichtung nach dem vorhergehenden Anspruch, **dadurch gekennzeichnet, dass** die oszillierende Bewegung des Auflagetisches (5) mit der Umlaufbewegung des tragenden Aufbaus (15) synchronisiert wird, so dass sich die Bürsten (16) in einer Längsrichtung bewegen, wenn sich der Auflagetisch (5) in der Gegenrichtung bewegt, und umgekehrt.

4. Vorrichtung nach dem vorhergehenden Anspruch, **dadurch gekennzeichnet, dass** sich die Geschwindigkeit der oszillierenden Bewegung des Auflagetisches (5) ändert, so dass die relative Längsgeschwindigkeit zwischen dem tragenden Aufbau (15) und dem Auflagetisch (5) im Wesentlichen konstant ist.

5. Vorrichtung nach dem vorhergehenden Anspruch, **dadurch gekennzeichnet, dass** der Auflagetisch (5) linear beschleunigt wird, wenn er die Endpunkte seiner oszillierenden Bewegung erreicht.

6. Vorrichtung nach einem der vorhergehenden Ansprüche, **dadurch gekennzeichnet, dass** der die Bürsten (16) tragende Aufbau (15) auf dem Trägerrahmen (20) mittels eines oder mehrerer Kurbelarme (21) exzentrisch drehbar gelagert ist und mit dem zweiten Motor (22) mittels eines Kurbelübertragungssystems (23) verbunden ist.

7. Vorrichtung nach dem vorhergehenden Anspruch, **dadurch gekennzeichnet, dass** der Abstand zwischen den Achsen der Bürsten (16) und der Hub der oszillierenden Bewegung des Auflagetisches (5) im Wesentlichen dem Zweifachen des Radius (R) der Umlaufbewegung entsprechen.

8. Vorrichtung nach einem der vorhergehenden Ansprüche, **dadurch gekennzeichnet, dass** der Auflagetisch (5) auf einer Beförderungsplatte (11) lösbar befestigt ist, die mittels eines dritten Motors (13) mittels eines Übertragungssystems bewegt werden kann, das ein Paar Ketten (14) aufweist, das mit der Platte (11) verbunden ist.

9. Vorrichtung nach dem vorhergehenden Anspruch, **dadurch gekennzeichnet, dass** die Drehbewegung der Wellen des zweiten Motors (22) und des dritten Motors (13) mit einem elektrischen oder elektronischen System gesteuert wird, insbesondere mit einem System, das einen Inverter mit einem Codierer kombiniert.

10. Vorrichtung nach einem der vorhergehenden Ansprüche, **dadurch gekennzeichnet, dass** der Auflagetisch (5) auf einer schrägen Ebene (10), insbesondere in einem Winkel (α) von ca. 20° gleitend angeordnet ist, die parallel zu dem die Bürsten (16) tragenden Aufbau (15) angeordnet ist.

11. Vorrichtung nach dem vorhergehenden Anspruch, **dadurch gekennzeichnet, dass** die schräge Ebene (10) höhenverstellbar angeordnet ist.

12. Vorrichtung nach einem der vorhergehenden Ansprüche, **dadurch gekennzeichnet, dass** die Bewegung der Welle des ersten Motors (18) auf die Bürsten (16) mittels eines Übertragungssystems übertragen wird, das eine Kette (19) aufweist, die zickzackförmig um Zahnräder gespannt ist, die auf den Wellen (17) der Bürsten (16) aufgekeilt sind.

13. Vorrichtung nach einem der vorhergehenden Ansprüche, **dadurch gekennzeichnet, dass** der erste Motor (18) seine Drehrichtung periodisch ändert.

14. Vorrichtung nach einem der vorhergehenden Ansprüche, **dadurch gekennzeichnet, dass** sie eine Pumpe (25) aufweist, die Flüssigkeiten für die Behandlung der Druckplatte (7) während des Betriebs der Bürsten (16) durch mehrere Kanäle (26) zu einer Reihe linearer Sprinkler (27) pumpt, die über den Bürsten (16) zwischen jeweils zwei Bürsten parallel zu ihren wellen (17) angeordnet sind.

15. Vorrichtung nach dem vorhergehenden Anspruch, **dadurch gekennzeichnet, dass** eine Bürste (16') mit ihrer eigenen Abdeckung (30) versehen ist, in der ein weiterer linearer Sprinkler (31) angeordnet ist.

16. Vorrichtung nach dem vorhergehenden Anspruch, **dadurch gekennzeichnet, dass** mindestens eine untere Kante der Abdeckung (30) ein radiales Wischerblatt (32) aufweist, das die Borsten der genannten Bürste (16') reinigt.

17. Vorrichtung nach einem der vorhergehenden Ansprüche, **dadurch gekennzeichnet, dass** der Trägerrahmen (20) entlang einer seiner Kanten mittels eines Scharniers (33) drehbar gelagert ist, so dass er nach oben gedreht werden kann.

## Revendications

1. Machine pour le traitement de plaques d'impression, qui. comprend au moins une structure (15) supportant en rotation une pluralité de brosses (16) de forme sensiblement cylindrique dont les arbres (17) sont mutuellement parallèles et sont agencés avec leurs axes dans un même plan parallèle à une table de support (5) sur laquelle est fixée au moins une plaque d'impression (7) à traiter, lesdites brosses (16) étant adaptées pour être mises en rotation par au moins un premier moteur (18) afin de brosser une surface de la plaque d'impression (7), **caractérisée en ce que** ladite structure de support (15) pivote de manière excentrée sur un cadre de support (20) de sorte qu'elle puisse être déplacée par un deuxième moteur (22) avec un mouvement orbital le long d'un plan parallèle à la table de support (5).

2. Machine selon la revendication précédente, **caractérisée en ce que**, pendant le mouvement orbital de la structure de support (15), la table de support (5) est déplacée longitudinalement avec un mouvement oscillatoire linéaire.

3. Machine selon la revendication précédente, **caractérisée en ce que** le mouvement oscillatoire de la table de support (5) est synchronisé avec le mouvement orbital de la structure de support (15), de sorte que, lorsque les brosses (16) se déplacent dans une direction longitudinale, la table de support (5) se déplace dans la direction opposée, et vice versa.

4. Machine selon la revendication précédente, **caractérisée en ce que** la vitesse du mouvement oscillatoire de la table de support (5) varie, de sorte que la vitesse longitudinale relative entre la structure de support (15) et la table de support (5) soit sensiblement constante.

5. Machine selon la revendication précédente, **caractérisée en ce que** la table de support (5) est accélérée linéairement lorsqu'elle atteint les extrémités de son mouvement oscillatoire.

6. Machine selon l'une des revendications précédentes, **caractérisée en ce que** la structure (15) supportant les brosses (16) pivote de manière excentrée sur le cadre de support (20) par l'intermédiaire d'un ou de plusieurs vilebrequins (21) et est reliée au deuxième moteur (22) par l'intermédiaire d'un système de transmission à vilebrequin (23).

7. Machine selon la revendication précédente, **caractérisée en ce que** la distance entre les axes des brosses (16) et la course du mouvement oscillatoire de la table de support (5) sont sensiblement égales à deux fois le rayon R du mouvement orbital.

8. Machine selon l'une des revendications précédentes, **caractérisée en ce que** la table de support (5) est fixée de manière amovible à une plaque de transport (11) adaptée pour être déplacée par un troisième moteur (13) par l'intermédiaire d'un système de transmission comprenant deux chaînes (14) fixées à la plaque (11).

9. Machine selon la revendication précédente, **caractérisée en ce que** la rotation des arbres des deuxième (22) et troisième (13) moteurs est commandée par un système électrique ou électronique, en particulier un système combinant un onduleur avec un codeur.

10. Machine selon l'une des revendications précédentes, **caractérisée en ce que** la table de support (5) est agencée de manière coulissante sur un.plan incliné (10), en particulier selon un angle (α) d'environ 20°, qui est parallèle à la structure (15) supportant les brosses (16).

11. Machine selon la revendication précédente, **caractérisée en ce que** le plan incliné (10) est ajustable en hauteur.

12. Machine selon l'une des revendications précédentes, **caractérisée en ce que** le mouvement de l'arbre du premier moteur (18) est transmis aux brosses (16) par l'intermédiaire d'un système de transmission comprenant une chaîne (19) tendue en zigzag autour de roues dentées clavetées sur les arbres (17) des brosses (16).

13. Machine selon l'une des revendications précédentes, **caractérisée en ce que** le premier moteur (18) inverse périodiquement son sens de rotation.

14. Machine selon l'une des revendications précédentes, **caractérisée en ce qu'**elle comprend une pompe (25) pompant des liquides pour le traitement de la plaque d'impression (7) pendant le fonctionnement des brosses (16) à travers une pluralité de conduits (26) jusqu'à une série de gicleurs linéaires (27) agencés au-dessus des brosses (16), entre une brosse et l'autre, parallèles aux bras (17) de celles-ci.

15. Machine selon la revendication précédente, **caractérisée en ce qu'**une brosse (16') est pourvue de son propre couvercle (30), à l'intérieur duquel un gicleur linéaire supplémentaire (31) est agencé.

16. Machine selon la revendication précédente, **caractérisée en ce qu'**au moins un bord inférieur du couvercle (30) comprend une raclette radiale (32) adaptée pour nettoyer les poils de ladite brosse (16').

17. Machine selon l'une des revendications précédentes, **caractérisée en ce que** le cadre de support (20) pivote le long d'un de ses bords par l'intermédiaire d'une articulation (33), de sorte qu'il puisse être tourné vers le haut.
